# EUROPEAN PATENT APPLICATION

(11) **EP 2 224 486 A2**
(43) Date of publication of application: **01.09.2010**
(21) Application number: 10153785.0
(22) Date of filing: 17.02.2010
(51) Int. Cl.: H01L 27/146

(54) **Quad flat non-leaded chip package structure**

(30) Priority: 25.02.2009 TW 98106002
(71) Applicant: Everlight Electronics Co., Ltd., Tucheng City / Taipei County (TW)
(72) Inventor: Lai, Lu-Ming, Taipei, Taiwan, ROC (TW)
(74) Representative: Chamberlain, Alan James

(57) **Abstract**

A quad flat non-leaded chip package structure includes a leadframe, a control chip, a light-sensing chip, a first bonding wire, a plurality of second bonding wires, and a molding compound. The leadframe includes a plurality of leads. Besides, the leadframe has an upper surface and a lower surface opposite to the upper surface. The control chip and the light-sensing chip are disposed on the upper surface of the leadframe. The light-sensing chip is electrically connected to the control chip through the first bonding wire. The control chip is electrically connected to the leads through the second bonding wires. The molding compound encapsulates a portion of the leadframe, the control chip, the light-sensing chip, the first bonding wire, and the second bonding wires. In addition, the molding compound fills among the leads.

## Description

### BACKGROUND OF THE INVENTION

### Field of the Invention

The present invention relates to a chip package structure. More particularly, the present invention relates to a quad flat non-leaded (QFN) chip package structure.

### Description of Related Art

A conventional infrared receiving module is fabricated by first packaging a semiconductor chip equipped with an infrared sensing function on a substrate, a leadframe, or other types of carriers and then welding the infrared-sensing semiconductor chip onto a printed circuit board through soldering, so as to form the infrared receiving module. However, the printed circuit board used herein needs not only to satisfy high-temperature reflow requirements but also to comply with the "Restriction of the Use of Hazardous Substances in Electrical and Electronic Equipment Regulations ("RoHS Regulations" for short)" regulated by the European Union and the non-halogen environmental requirement. Thereby, the use of the printed circuit board is restrained.

Besides, in order to be compliant with the trend of miniaturization, it is necessary for the printed circuit board to be miniaturized. Moreover, semi-blind holes should also be formed on the printed circuit board, such that the infrared receiving module can receive the infrared light either when the infrared receiving module is placed horizontally (i.e., a infrared-sensing semiconductor chip faces up) or when the infrared receiving module is placed laterally (i.e., the infrared-sensing semiconductor chip faces left or right). Nonetheless, the printed circuit board having a compact size and the design of the semi-blind holes is formed with relatively high manufacturing costs. In addition, the metal layer remaining on the semi-blind holes should be often scraped off, which additionally increases labor costs.

The infrared receiving module having the infrared-sensing semiconductor chip can receive the infrared light either when the infrared receiving module is placed horizontally or when the infrared receiving module is placed laterally, given that the infrared-sensing semiconductor chip is disposed on a leadframe formed by bending exposed metal leads. However, the leadframe formed by bending the exposed metal leads has relatively large volume and great thickness, which is contrary to the current trend of miniaturization.

### SUMMARY OF THE INVENTION

The present application is directed to a quad flat non-lead (QFN) chip package structure capable of reducing manufacturing costs and having relatively small package volume.

In the application, a QFN chip package structure includes a leadframe, a control chip, a light-sensing chip, a first bonding wire, a plurality of second bonding wires, and a molding compound. The leadframe has an upper surface and a lower surface opposite thereto, and the leadframe includes a plurality of leads. The control chip is disposed on the upper surface of the leadframe. The light-sensing chip is disposed on the upper surface of the leadframe. The first bonding wire connects the control chip and the light-sensing chip, such that the light-sensing chip and the control chip are electrically connected. The second bonding wires connect the control chip and the leads, such that the control chip and the leads are electrically connected. The molding compound encapsulates a portion of the leadframe, the control chip, the light-sensing chip, the first bonding wire, and the second bonding wires. In addition, the molding compound fills among the leads.

According to an embodiment of the present invention, the leadframe further includes a die pad. The control chip and the light-sensing chip are disposed on the die pad, and the leads are located around the die pad.

According to an embodiment of the present invention, one of the leads and the die pad are integrally formed.

According to an embodiment of the present invention, the molding compound has at least a first positioning portion, and the first positioning portion is a recess or an opening.

According to an embodiment of the present invention, the QFN chip package structure further includes a metal conductive element. The metal conductive element is disposed on the lower surface of the leadframe. The molding compound encapsulates a portion of the metal conductive element and exposes a surface of the metal conductive element relatively away from the leadframe.

According to an embodiment of the present invention, the metal conductive element has a second positioning portion disposed on the surface of the metal conductive element relatively away from the leadframe.

According to an embodiment of the present invention, each of the leads located at the lower surface has a recess located at an outer edge of the lead , and the recess has an arc shape.

According to an embodiment of the present invention, the light-sensing chip receives a light signal passing the molding compound, and a wavelength of the light signal ranges from 770 nm to 1100 nm.

According to an embodiment of the present invention, the light-sensing chip is a photodiode or a phototransistor.

According to an embodiment of the present invention, the leads include an output lead and an input lead.

According to an embodiment of the present invention, the molding compound absorbs light in a waveband of visible light.

Based on the above, the light-sensing chip of the present invention is disposed on a conductive leadframe, and the molding compound merely exposes the surface where the leads that are able to serve as external contact points are located. Therefore, the QFN chip package structure of the application can either be placed horizontally (i.e., the light-sensing chip faces up) or be placed laterally (i.e., the light-sensing chip faces left or right), such that the light-sensing chip receives the light signal passing the molding compound. Moreover, because of the conductive properties of the leadframe, the die pad can be directly grounded. As such, manufacturing efficiency of the chip package structure can be improved, while manufacturing costs and size of the chip package structure can be reduced.

In order to make the aforementioned and other features and advantages of the present invention more comprehensible, several embodiments accompanying figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a schematic top view of a QFN chip package structure according to an embodiment of the present invention.

FIG. 2 is a schematic bottom view of the QFN chip package structure depicted in FIG. 1.

FIG. 3 is a schematic three-dimensional back view of the QFN chip package structure depicted in FIG. 1.

### DESCRIPTION OF EMBODIMENTS

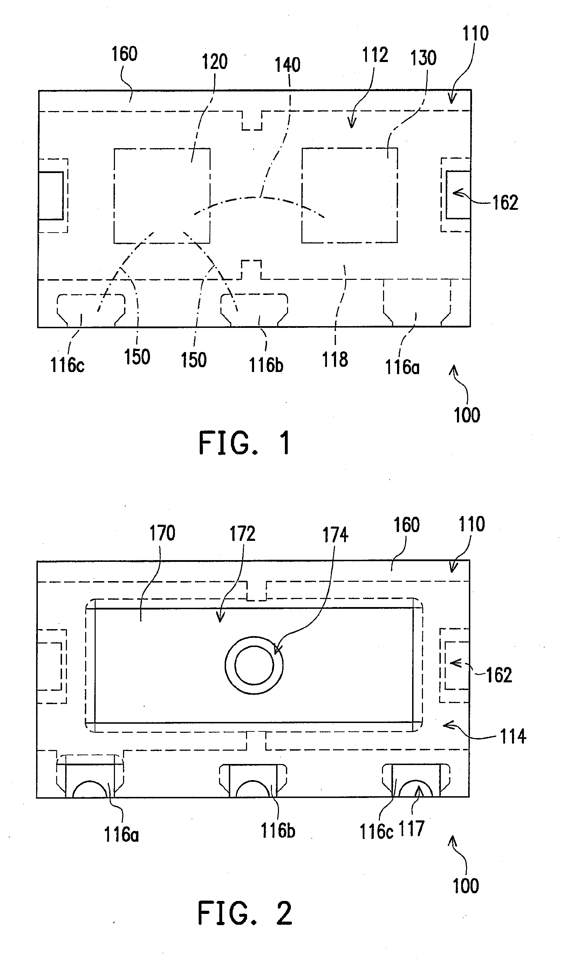

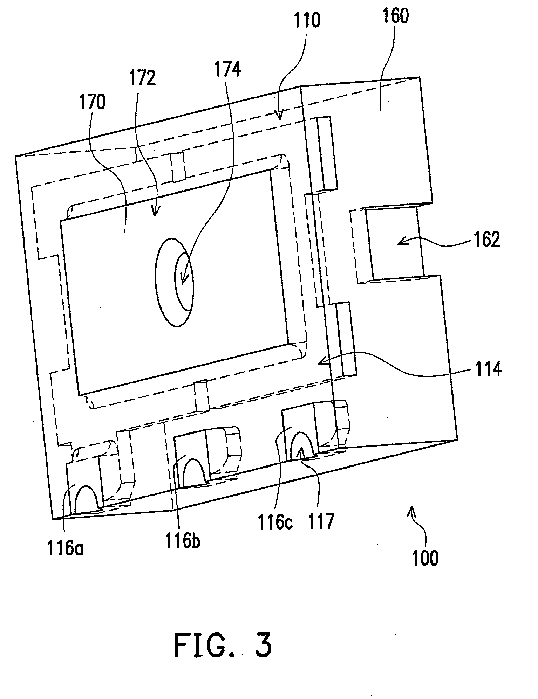

FIG. 1 is a schematic top view of a QFN chip package structure according to an embodiment of the present invention. FIG. 2 is a schematic bottom view of the QFN chip package structure depicted in FIG. 1. FIG. 3 is a schematic three-dimensional back view of the QFN chip package structure depicted in FIG. 1. Referring to FIGs. 1, 2, and 3, in the present embodiment, the QFN chip package structure 100 includes a leadframe 110, a control chip 120, a light-sensing chip 130, a first bonding wire 140, a plurality of second bonding wires 150, and a molding compound 160.

Specifically, the leadframe 110 has an upper surface 112 and a lower surface 114 opposite to the upper surface 112. Besides, the leadframe 110 includes a plurality of leads 116a∼116c and a die pad 118. The leads 116a∼116c are located around the die pad 118, and the leads 116a∼116c located at the lower surface respectively have a recess 116a located at an outer edge of the leads 116a∼116c. The recess 116a which can serve as an alignment mark has an arc shape, for example. Note that the leadframe 110 can be made of a metal conductive material in the present embodiment, and the lead 116a and the die pad 118 are integrally formed. The lead 116a and the die pad 118 that are integrally formed can be considered as a grounded lead.

Both the control chip 120 and the light-sensing chip 130 are disposed on the upper surface 112 of the leadframe 110 and are located on the die pad 118. Here, the light-sensing chip 130 receives a light signal from the molding compound 160 and converts the received light signal into an electric signal. The light signal has a wavelength ranging from 770 nm to 1100 nm. That is to say, the light-sensing chip 130 receives a light signal in an infrared waveband, and the control chip 120 has functions of coding, decoding, and/or logic operation. Particularly, in the present embodiment, the light-sensing chip 130 is, for example, a photodiode or a phototransistor.

The first bonding wire 140 connects the control chip 120 and the light-sensing chip 130, such that the light-sensing chip 130 is electrically connected to the control chip 120 through the first bonding wire 140. That is to say, the light-sensing chip 130 can receive the light signal, convert the received light signal into an electric signal, and output the electric signal which be transmitted to the control chip 120 through the first bonding wire 140. Next, the control chip 120 can code, decode, or perform a logic operation on the light signal received by the light-sensing chip 130.

Two second bonding wires 150 respectively connect the control chip 120 and the lead 116b and connect the control chip 120 and the lead 116c, such that the control chip 120 is electrically connected to the leads 116b and 116c through the two second bonding wires 150. Here, the lead 116b is an output lead, while the lead 116c is an input lead. In general, the input lead is a power terminal supplying the control chip 120 with electric energy for use. The output lead is a signal-outputting terminal. Through the output lead, the light signal which is coded, decoded, or logically operated by the control chip 120 is output in most cases, and the control chip 120 is electrically connected to external circuits. Note that the types of the leads 116b and 116c are not limited in the present invention. The leads 116b and 116c discussed herein respectively refer to an output lead and an input lead. However, the leads 116b and 116c in other embodiments can also be an input lead and an output lead, respectively, which is still a part of the technical proposal of the present application and is not departing from the scope of protection sought by the present application.

The molding compound 160 encapsulates a portion of the leadframe 110, the control chip 120, the light-sensing chip 130, the first bonding wire 140, and the two second bonding wires 150. Besides, the molding compound 160 fills among the leads 116a∼116c. Here, the lower surface 114 where the leads 116a∼116c are located is exposed, and therefore the leads 116a∼116c can serve as electrical contact points electrically connecting external apparatuses. In the present embodiment, the molding compound 160 blocks most of the light in a waveband of visible light (e.g., close to an infrared waveband) from entering the light-sensing chip 130, such that noises generated when the light-sensing chip 130 receives the light signal can be reduced. In addition, the molding compound 160 has two first positioning portions 162 that are respectively located at side edges of the molding compound 160 and serve as alignment marks. Here, the first positioning portions 162 are recesses or openings, for example.

According to the present embodiment, the light-sensing chip 130 is disposed on the leadframe 110 having the conductive properties, and the molding compound 160 merely exposes the lower surface 114 where the leads 116a∼116c that can act as the external contact points are located. Therefore, due to the conductive properties of the leadframe 110 in the QFN chip package structure 100 of the present embodiment, no matter the leadframe 110 is placed horizontally (i.e., the light-sensing chip 130 faces up) or laterally (i.e., the light-sensing chip 130 faces left or right), the light signal passing the molding compound 160 can be received by the light-sensing chip 130, and the light signal has a wavelength ranging from 770 nm to 1100 nm.

Additionally, the molding compound 160 encapsulates a portion of the leadframe 110 and simply exposes the lower surface 114 where the leads 116a∼116c capable of serving as the external contact points are located. In comparison with the conventional infrared receiving module, the QFN chip package structure 100 of the present embodiment can be compliant with the requirement for miniaturization. On the other hand, the leadframe 110 of the present embodiment has conductive properties, and therefore the die pad 118 can be directly grounded without being additionally conducted, so as to lower down the costs and reduce restrictions on the shape and the appearance of the chip package structure.

Furthermore, the QFN chip package structure 100 of the present embodiment further includes a metal conductive element 170 disposed on the lower surface 114 of the leadframe 110. The molding compound 160 encapsulates a portion of the metal conductive element 170 and exposes a surface 172 of the metal conductive element 170 relatively away from the leadframe 110. Note that the metal conductive element 170 herein can act as a heat dissipation element for dissipating thermal energy from the surface 172 which is not encapsulated by the molding compound 160. Here, the thermal energy is generated by the control chip 120 and the light-sensing chip 130. Alternatively, the metal conductive element 170 can be grounded, such that the surface 172 which is not encapsulated by the molding compound 160 can also be grounded directly.

Besides, the metal conductive element 170 has a second positioning portion 174 disposed on the surface 172 of the metal conductive element 170 relatively away from the leadframe 110. The second positioning portion 174 can serve as an alignment mark. When the QFN chip package structure 100 is electrically connected to other external apparatuses, not only the second positioning portion 174 of the metal conductive element 170 can be used to perform an alignment function, but also the first positioning portions 162 of the molding compound 160 or the recesses 117 of the leads 116a∼116c can be employed to do the alignment.

In light of the foregoing, the light-sensing chip of the present application is disposed on the leadframe having the conductive properties, and the molding compound simply exposes the surface where the leads that can act as the external contact points are located. Hence, the leadframe in the QFN chip package structure of the present application can be placed horizontally (i.e., the light-sensing chip faces up) or laterally (i.e., the light-sensing chip faces left or right), such that the light-sensing chip can receive the light signal passing the molding compound. Moreover, owing to the conductive properties of the leadframe, the die pad can be directly grounded, so as to promote production efficiency of the chip package structure, reduce the manufacturing costs, and downsize the chip package structure.

Although the present invention has been described with reference to the above embodiments, it will be apparent to one of the ordinary skill in the art that modifications to the described embodiment may be made without departing from the spirit of the invention. Accordingly, the scope of the invention will be defined by the attached claims not by the above detailed descriptions.

## Claims

1. A quad flat non-leaded chip package structure, comprising:
a leadframe (110) having an upper surface (112) and a lower surface (114) opposite to the upper surface (112), the leadframe (110) comprising a plurality of leads (116a∼116c);
a control chip (120) disposed on the upper surface (112) of the leadframe (110);
a light-sensing chip (130) disposed on the upper surface (112) of the leadframe (110);
a first bonding wire (140) connecting the control chip (120) and the light-sensing chip (130), such that the light-sensing chip (130) is electrically connected to the control chip (120);
a plurality of second bonding wires (150) connecting the control chip (120) and the leads (116a∼116c), such that the control chip (120) is electrically connected to the leads (116a∼116c); and
a molding compound (160) encapsulating a portion of the leadframe (110), the control chip (120), the light-sensing chip (130), the first bonding wire (140), and the second bonding wires (150), the molding compound (160) filling among the leads (116a∼116c).

2. The quad flat non-leaded chip package structure as claimed in claim 1, wherein the leadframe (110) further comprises a die pad (118) on which the control chip (120) and the light-sensing chip (130) are disposed, and the leads (116a∼116c) are located around the die pad (118).

3. The quad flat non-leaded chip package structure as claimed in claim 2, wherein one of the leads (116a∼116c) and the die pad (118) are integrally formed.

4. The quad flat non-leaded chip package structure as claimed in any of the preceding claims, wherein the molding compound (160) has at least a first positioning portion (162), and the first positioning portion (162) is a recess (117) or an opening.

5. The quad flat non-leaded chip package structure as claimed in any of the preceding claims, further comprising a metal conductive element (170) disposed on the lower surface (114) of the leadframe (110), the molding compound (160) encapsulating a portion of the metal conductive element (170) and exposing a surface of the metal conductive element (170) oppositely away from the leadframe (110).

6. The quad flat non-leaded chip package structure as claimed in claim 5, wherein the metal conductive element (170) has a second positioning portion (174) disposed on the surface of the metal conductive element (170) oppositely away from the leadframe (110).

7. The quad flat non-leaded chip package structure as claimed in any of the preceding claims, wherein each of the leads (116a∼116c) has a recess (116a) located at an outer edge of each the lead (116a∼116c) located on the lower surface (114) of the leadframe (110), and the recess (116a) has an arc shape.

8. The quad flat non-leaded chip package structure as claimed in any of the preceding claims, wherein the light-sensing chip (130) is used for receiving a light signal passing the molding compound (160), and a wavelength of the light signal is in a range of 770 nm to 1100 nm.

9. The quad flat non-leaded chip package structure as claimed in claim 8, wherein the light-sensing chip (130) is a photodiode or a phototransistor.

10. The quad flat non-leaded chip package structure as claimed in any of the preceding claims, wherein the leads (116a∼116c) comprise an output lead and an input lead.

11. The quad flat non-leaded chip package structure as claimed in any of the preceding claims, wherein the molding compound (160) used for absorbing a visible light.
